# EUROPEAN PATENT APPLICATION

(11) **EP 4 535 218 A1**
(43) Date of publication of application: **09.04.2025**
(21) Application number: 23815185.6
(22) Date of filing: 30.05.2023
(51) Int. Cl.: G06F 30/27, G06F 9/455

(54) **SIMULATION DEVICE, SIMULATION SYSTEM, SIMULATION METHOD, AND STORAGE MEDIUM**

(30) Priority: 31.05.2022 CN 202210613143
(71) Applicant: BEIJING YOUZHUJU NETWORK TECHNOLOGY CO. LTD., Beijing 101299 (CN)
(72) Inventor: LI, Tao, Beijing 100028 (CN); LUO, Haizhao, Beijing 100028 (CN); YUAN, Hangjian, Beijing 100028 (CN); SHI, Yunfeng, Beijing 100028 (CN); WANG, Jian, Beijing 100028 (CN)
(74) Representative: Dentons UK and Middle East LLP
(86) International application number: PCT/CN2023/097006
(87) International publication number: WO 2023/232006

(57) **Abstract**

Embodiments of the present disclosure provide a simulation device, a simulation system, a simulation method, and a non-transitory computer-readable storage medium. The simulation device is used for simulating a neural network processor, and comprises: an agent module configured to communicate with an object model which simulates the neural network processor, and serve as an agent of the object model in the simulation device; a management module configured to manage the simulation device; and an interconnection module configured to communicatively connect the agent module and the management module. The simulation device receives a task sent by a host, sends, to the object model by means of the agent module, working information related to the task, receives, by means of the agent module, feedback information returned by the object model after processing the working information, and provides the feedback information to the host.

## Description

The present application claims priority to Chinese Patent Application No. 202210613143.4, filed on May 31, 2022, which is incorporated herein by reference in its entirety as a part of the present application.

### TECHNICAL FIELD

Embodiments of the present disclosure relate to a simulation apparatus, a simulation system and a simulation method therefor, and a non-transitory computer-readable storage medium.

### BACKGROUND

With the development of artificial intelligence, the number of parameters for an algorithm model has increased dramatically, which requires higher computing power. A conventional hardware architecture (e.g., a central processing unit (CPU)/a graphics processing unit (GPU)) takes the balance between different service requirements into consideration at an architectural design stage, resulting in limited computing power for AI applications. As a result, a domain-specific accelerator (DSA) has emerged. A core idea of the DSA is also to utilize dedicated hardware to do specialized things. The DSA caters to applications in a domain, rather than a fixed application, and therefore, the DSA can achieve a trade-off between flexibility and specialization.

### SUMMARY

This section is provided to give a brief overview of concepts, which will be described in detail later in the section Detailed Description of the Invention. This section is not intended to identify key or necessary features of the claimed technical solutions, nor is it intended to be used to limit the scope of the claimed technical solutions.

At least one embodiment of the present disclosure provides a simulation apparatus. The simulation apparatus is used for simulating a neural network processor, and includes: a proxy module configured to communicate with an object model which simulates the neural network processor, and to serve as a proxy for the object model in the simulation apparatus; a management module configured to manage the simulation apparatus; and an interconnection module configured to communicatively connect the proxy module and the management module. The simulation apparatus receives a task sent by a host, sends, via the proxy module, work information related to the task to the object model, receives, via the proxy module, feedback information returned by the object model after processing the work information, and provides the feedback information to the host.

At least one embodiment of the present disclosure further provides a simulation system. The simulation system includes: the simulation apparatus according to any one of the embodiments of the present disclosure, the object model, and the host, where the host is configured to obtain a task and send the task to the simulation apparatus; and the object model is configured to process work information to obtain feedback information.

At least one embodiment of the present disclosure further provides a simulation method applied to the simulation system according to any one of the embodiments of the present disclosure. The simulation method includes: sending a task by a host; receiving and parsing the task by the simulation apparatus, to send work information related to the task to an object model; processing the work information by the object model, to obtain feedback information; and providing the feedback information to the host by the simulation apparatus.

At least one embodiment of the present disclosure further provides a non-transitory computer-readable storage medium storing computer-executable instructions, where when the computer-executable instructions are executed by a processor, the simulation method according to any one of the above embodiments is implemented.

### BRIEF DESCRIPTION OF DRAWINGS

The foregoing and other features, advantages, and aspects of embodiments of the present disclosure become more apparent with reference to the following specific implementations and in conjunction with the accompanying drawings. Throughout the drawings, the same or similar reference numerals denote the same or similar elements. It should be understood that the accompanying drawings are schematic and that parts and elements are not necessarily drawn to scale.
FIG. 1A is a schematic diagram of a hardware architecture of a simulation apparatus according to at least one embodiment of the present disclosure;
FIG. 1B is a schematic diagram of a hardware architecture of another simulation apparatus according to at least one embodiment of the present disclosure;
FIG. 2 is a schematic diagram of a hardware architecture of a simulation system according to at least one embodiment of the present disclosure;
FIG. 3 is a schematic flowchart of a simulation method according to at least one embodiment of the present disclosure;
FIG. 4 is a schematic diagram of a non-transitory computer-readable storage medium according to at least one embodiment of the present disclosure; and
FIG. 5 is a schematic diagram of a hardware structure of an electronic device according to at least one embodiment of the present disclosure.

### DETAILED DESCRIPTION

The embodiments of the present disclosure are described in more detail below with reference to the accompanying drawings. Although some embodiments of the present disclosure are shown in the accompanying drawings, it should be understood that the present disclosure may be implemented in various forms and should not be construed as being limited to the embodiments set forth herein. Rather, these embodiments are provided for a more thorough and complete understanding of the present disclosure. It should be understood that the accompanying drawings and the embodiments of the present disclosure are only for exemplary purposes, and are not intended to limit the scope of protection of the present disclosure.

It should be understood that the various steps described in the method implementations of the present disclosure may be performed in different orders, and/or performed in parallel. Furthermore, additional steps may be included and/or the execution of the illustrated steps may be omitted in the method implementations. The scope of the present disclosure is not limited in this respect.

The term "include/comprise" used herein and the variations thereof are an open-ended inclusion, namely, "include/comprise but not limited to". The term "based on" is "at least partially based on". The term "an embodiment" means "at least one embodiment". The term "another embodiment" means "at least one another embodiment". The term "some embodiments" means "at least some embodiments". Related definitions of the other terms will be given in the description below.

It should be noted that concepts such as "first" and "second" mentioned in the present disclosure are only used to distinguish different apparatuses, modules, or units, and are not used to limit the sequence of functions performed by these apparatuses, modules, or units or interdependence.

It should be noted that the modifiers "one" and "a plurality of" mentioned in the present disclosure are illustrative and not restrictive, and those skilled in the art should understand that unless the context clearly indicates otherwise, the modifiers should be understood as "one or more".

The names of messages or information exchanged between a plurality of apparatuses in the implementations of the present disclosure are used for illustrative purposes only, and are not used to limit the scope of these messages or information.

After the development in recent years, the architectural design for an AI hardware accelerator has become increasingly complex. From an initial single-core shared memory, gradually to a current homogeneous multicore-distributed memory, the design of a core in the AI hardware accelerator has also evolved from a simple very long instruction word (VLIW) structure to a Turing complete instruction set architecture (ISA), where two implementation architectures for instruction-driven data access, including Master-Slave (a data block) and Data-Streaming (a data stream), coexist. For early architectural design, exploration and later verification for the AI hardware accelerator, a n improved simulation system for simulating the AI hardware accelerator becomes indispensable. In other words, the AI hardware accelerator currently lacks a simple and efficient simulation framework for architectural design and function verification.

Optimization strategies involved in an AI compiler mainly include operator fusion and splitting, IO/compute parallel scheduling, etc. These optimization strategies constitute a huge optimization search space. The optimization strategies are ultimately executed on an underlying accelerator with different efficiencies, and a cost-model is needed to evaluate each of the optimization strategies and reduce the optimization search space. The cost-model should be accurate enough without bringing about too much overheads at a compilation stage. At present, an open-source full-system simulation platform includes a gem5 simulator. The main disadvantages of the gem5 simulator are as follows. The gem5 simulator has a complicated system and a low execution efficiency; it is not designed for AI accelerator modeling; and as a cost-model, it leads to too much overheads. Therefore, at present, the AI compiler requires a high-performance cost-model for evaluation.

At least one embodiment of the present disclosure provides a simulation apparatus. The simulation apparatus is used for simulating a neural network processor, and includes: a proxy module, a management module, and an interconnection module. The proxy module is configured to communicate with an object model which simulates the neural network processor, and to serve as a proxy for the object model in the simulation apparatus. The management module is configured to manage the simulation apparatus. The interconnection module is configured to communicatively connect the proxy module and the management module. The simulation apparatus receives a task sent by a host, sends, via the proxy module, work information related to the task to the object model, receives, via the proxy module, feedback information returned by the object model after processing the work information, and provides the feedback information to the host.

By means of the simulation apparatus provided in the embodiments of the present disclosure, a full-system simulation platform of the neural network processor is modeled, such that the architectural design and exploration of as well as function verification for the neural network processor can be effectively implemented, and the structural and functional design of the neural network processor can be accelerated, thereby avoiding a limitation on the development of the neural network processor due to hardware. Furthermore, the simulation apparatus is simple in structure and easy to implement.

At least one embodiment of the present disclosure further provides a simulation system and a simulation method therefor, and a non-transitory computer-readable storage medium.

The embodiments of the present disclosure are described in detail below with reference to the accompanying drawings. However, the present disclosure is not limited to these specific embodiments. Detailed description of some known functions and known components is omitted in the present disclosure, to make the following description of the embodiments of the present disclosure clear and concise.

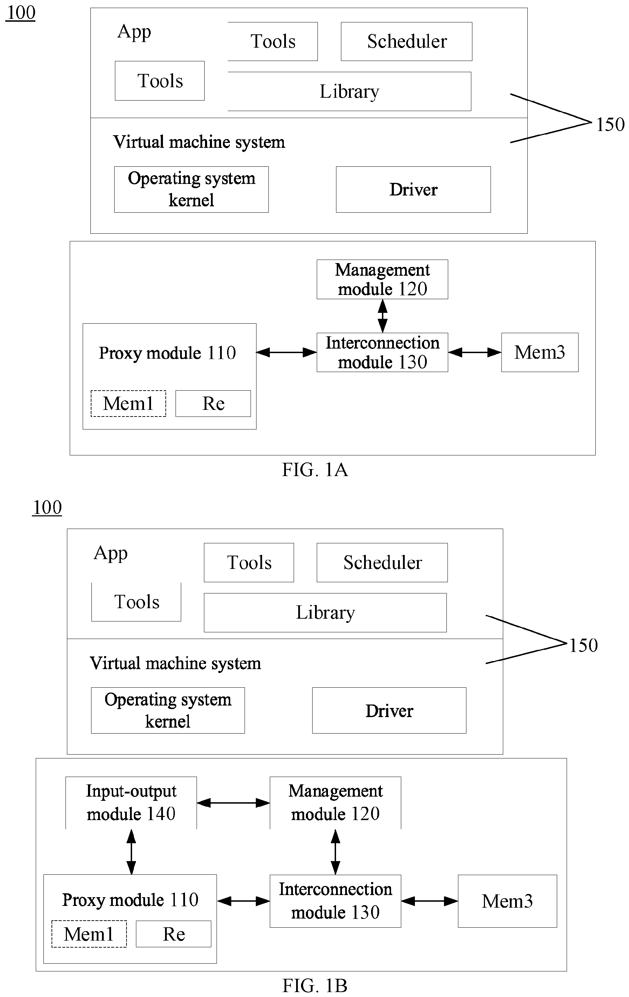

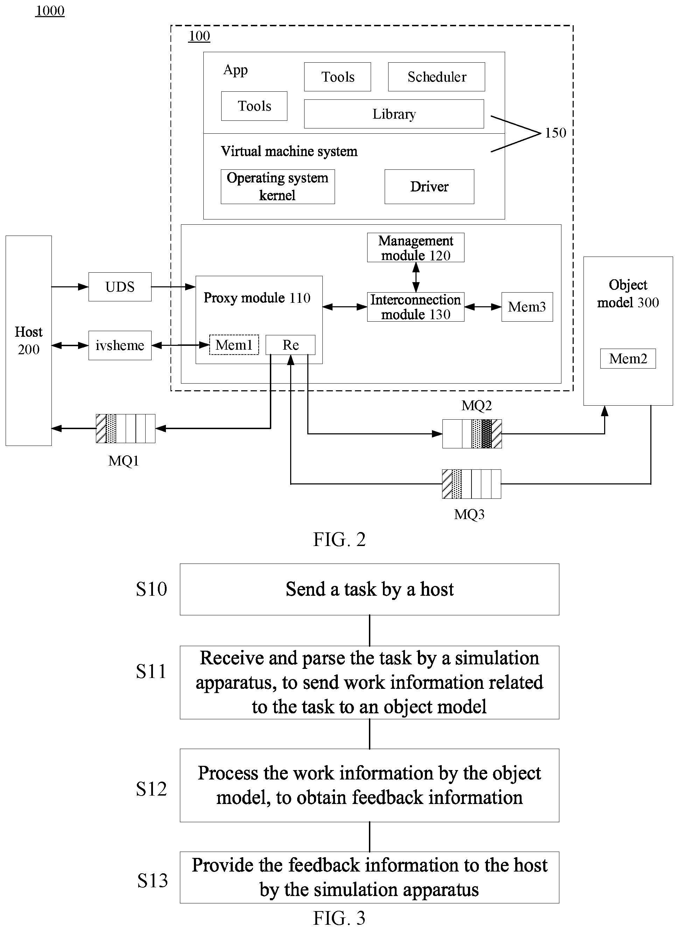

FIG. 1A is a schematic diagram of a hardware architecture of a simulation apparatus according to at least one embodiment of the present disclosure; FIG. 1B is a schematic diagram of a hardware architecture of another simulation apparatus according to at least one embodiment of the present disclosure; and FIG. 2 is a schematic diagram of a hardware architecture of a simulation system according to at least one embodiment of the present disclosure.

The simulation apparatus provided in the embodiment of the present disclosure can be used for simulating a neural network processor. The neural network processor may be implemented in the form of hardware, for example, implemented as a chip based on a programming language. For example, the neural network processor may be used for implementing convolution operations, matrix operations, etc.

As shown in FIG. 1A and FIG. 1B, in some embodiments of the present disclosure, the simulation apparatus 100 may include a proxy module 110, a management module 120, and an interconnection module 130. As shown in FIG. 2, the proxy module 110 is configured to communicate with an object model 300 which simulates the neural network processor, and to serve as a proxy for the object model in the simulation apparatus 100, that is, the object model 300 is used for simulating functions of the neural network processor. The management module 120 is configured to manage the simulation apparatus 100. The interconnection module 130 is configured to communicatively connect the proxy module 110 and the management module 120. It should be noted that although the simulation apparatus 100 shown in FIG. 2 is the simulation apparatus shown in FIG. 1A, the simulation apparatus 100 in a simulation system 1000 may also be the simulation apparatus shown in FIG. 1B.

For example, the management module 120 may manage the proxy module 110 to control the proxy module 110 to perform corresponding functions.

For example, as shown in FIG. 2, the simulation apparatus 100 receives a task sent by a host 200, sends, via the proxy module 110, work information related to the task to the object model, receives, via the proxy module 110, feedback information returned by the object model after processing the work information, and provides the feedback information to the host 200.

For example, the simulation apparatus 100 is implemented through a virtual simulation platform. For example, the simulation apparatus 100 may be implemented as a Quick EMUlator (QEMU) virt platform, etc.

For example, the management module 120 is implemented through a virtual central processing unit. For example, in some embodiments, the virtual central processing unit may be a reduced instruction set computer (RISC)-V (V denotes a fifth-generation RISC) core.

For example, the task may be any task that needs to be executed by the neural network processor, e.g., target identification, matrix operations (e.g., matrix multiplication operations), etc.

For example, the proxy module 110 may communicate with the host 200 in at least one mode including, for example, a socket, shared storage, and/or a message queue. As shown in FIG. 2, in some embodiments, the proxy module 110 communicates with the host 200 by means of a socket, shared storage, and a message queue. The socket may be a Unix domain socket (UDS). The shared storage means that communication is performed through a shared storage file. For example, the shared storage file may be a /dev/shm/ivshmem file in the host 200. The ivshmem file enables sharing of a memory area created by the host 200 among processes of different QEMUs. A message queue MQ1 may deliver a message in a first input first output (FIFO) mode.

For example, between the proxy module 110 and the host 200, communication of data in a large data volume is implemented by means of the shared storage, while communication of data in a small data volume is implemented by means of the socket and/or the message queue.

For example, the proxy module 110 may also communicate with the object model 300 in at least one mode. For example, the proxy module 110 communicates with the object model 300 by means of a message queue. As shown in FIG. 2, in some embodiments, the proxy module 110 communicates with the object model 300 by means of the message queue. For example, the proxy module 110 sends the work information related to the task to the object model 300 by means of a message queue MQ2, and the object model 300 sends the feedback information to the proxy module 110 by means of a message queue MQ3. Similarly, the message queue MQ2 and the message queue MQ3 may deliver messages in an FIFO mode.

For example, the object model 300 may be connected to the simulation apparatus 100 in a pluggable manner, i.e., the simulation apparatus 100 may simulate different object models. For example, different object models may simulate different neural network processors.

For example, the object model 300 can improve the operation speed of the neural network processor, save the operation time, and improve the operation efficiency.

For example, as shown in FIG. 2, the host 200 may obtain a task from an external device, and send the task to the simulation apparatus 100 by means of the socket.

For example, information, such as parameters of the neural network processor and inputs and/or outputs related to the task, is accessed by the host 200 and the simulation apparatus 100 by means of the shared storage, to perform read or write operations. For example, the inputs and/or outputs related to the task may be determined depending on the type of the task. For example, in some embodiments, the task may be to identify a target object in an image and feed the image with the target object labeled back to the host 200. In this case, the input image may be an input related to the task, and the image with the target object labeled that is identified by the object model 300 may be an output related to the task.

For example, the simulation apparatus 100 may send (e.g., synchronize) the feedback information to the host 200 by means of the message queue.

For example, in some embodiments, as shown in FIG. 1B, the simulation apparatus 100 may further include an input-output module 140. The input-output module 140 may interact with the host 200, e.g., communicate with the host 200 by means of a socket, to receive the task. For example, the input-output module 140 is configured to send the task to the proxy module 110 or the management module 120. For example, the input-output module 140 may include a buffer, etc. for storing the task.

For example, as shown in FIG. 1A and FIG. 1B, an address space of the proxy module 110 may include a proxy register space Re and a model space Mem1.

For example, the proxy register space Re is used for defining registers of the neural network processor. The registers of the neural network processor are all memory mapped, where "memory mapped" refers to unified addressing of registers of a device and a memory, that is, use of the memory address to locate the registers of the device, such that the registers of the neural network processor are defined in a memory space, and can be located by means of memory addresses, so as to implement reading and writing.

For example, the proxy register space Re may communicate with the host 200 and the object model 300 by means of a message queue.

For example, the model space Mem1 is used for storing parameters of the neural network processor and the inputs and/or outputs related to the task, etc.

For example, in some embodiments, the model space Mem1 is shared with the host 200 by the proxy module 110. In this case, the model space Mem1 communicates with the host 200 by means of shared storage, for example.

For example, in some embodiments, as shown in FIG. 2, the model space Mem1 may be mapped to a storage space Mem2 in the object model. It can be seen therefrom that the model space Mem1 and the storage space Mem2 are the same address space, and the actual storage is mapped to the shared storage file in the host 200. That is, the model space Mem1 can be actually accessed by the simulation apparatus 100, the host 200, and the object model 300. For example, the host 200 writes the information, such as the parameters of the neural network processor and the inputs and/or outputs related to the task, into the model space Mem1, and then the object model 300 can directly read the information, such as the inputs and/or outputs related to the task, written into the model space Mem1 for relevant processing.

For example, in some embodiments, as shown in FIG. 2, the address space of the proxy module 110 may further include a configuration instruction space Mem3. The configuration instruction space Mem3 is used for storing configuration instructions of the registers of the neural network processor and control instructions related to the task.

For example, in some embodiments, the proxy module 110, the management module 120, and the interconnection module 130 may be mounted into a high-speed serial computer expansion bus (peripheral component interconnect express, PCIe) system. The PCIe system can include the following several types of devices: a root complex (RC), a bridge, a switch, an endpoint, etc. The root complex is an interface between a CPU and a PCIe bus. The bridge provides an interface with another bus (such as a PCI or a PCI-x, and even another PCIe bus), and is sometimes also referred to as a forwarding bridge. The switch provides an extension or aggregation capability, and allows more devices to connect to a PCIe port. As a PCIe-to-PCIe bridge, the switch can serve as a packet router, and identify which path a given packet needs to follow based on an address or other routing information. The endpoint is at the very end of a topology of the PCIe bus system, typically serving as either an initiator (similar to a master in a PCI bus) or a completer (similar to a slave in the PCI bus) of the bus operation.

For example, in some embodiments, the interconnection module 130 may be the root complex in the PCIe system.

For example, in some embodiments, the proxy module 100 may be the endpoint in the PCIe system. For example, the proxy module 100 may include a plurality of base address register (BAR) spaces, and the plurality of base address register spaces include a first base address register space and a second base address register space. In some embodiments, the plurality of base address register spaces may include a BRAO space to a BRAS space, where the first base address register space may be the BRAO space, and the second base address register space may be a BRA3 space.

For example, the proxy register space Re corresponds to the first base address register space, e.g., to the BRAO space, and the configuration instruction space Mem3 corresponds to the second base address register space, e.g., to the BRA3 space. The base address register space refers to the BAR space of the PCIe. The simulation apparatus, as a device of the host, is connected to the host via the PCIe interface. The host needs to map the space on the simulation apparatus to the BAR space of the PCIe in order to access the simulation apparatus. If there are a plurality of independent accessible spaces on the simulation apparatus, the PCIe provides a plurality of BAR spaces for mapping.

For example, the configuration instruction space Mem3 is mapped to a shared storage file ivshmem shared by the proxy module 110 and the host 200, and the shared storage file ivshmem is located at the host 200. That is, in the simulation apparatus 100, all accesses to the BAR3 space are forwarded to the shared storage file ivshmem on the host 200, and the host 200 implements the sending of configuration instructions to the proxy module 110 in the simulation apparatus 100 by writing the shared storage file ivshmem.

For example, in some embodiments of the present disclosure, as shown in FIG. 2, the actual storage of the model space Mem1, the storage space Mem2, and the configuration instruction space Mem3 is mapped to the shared storage file in the host 200. It should be noted that the model space Mem1 and the storage space Mem2 may be mapped to the same position in the shared storage file, while the configuration instruction space Mem3 is mapped to a different position in the shared storage file than a position where the model space Mem1/the storage space Mem2 is mapped to in the shared storage file.

For example, the proxy module 110 is configured to: provide content in the proxy register space Re and content in the model space Mem1 to the object model 300 based on content in the configuration instruction space Mem3, to configure and schedule the object model 300 and perform work simulation. It should be noted that when the model space Mem1 can be mapped to the storage space Mem2 in the object model, the object model 300 can directly access the model space Mem1 to obtain required data, such as the inputs related to the task.

For example, the host 200 may pull an interrupt to the proxy module 110 by means of a socket, i.e., the task sent by the host 200 and executed by the object model 300 may be executed in an interrupt mode.

For example, in some embodiments, the proxy module 110 may include an interrupt register, and the host writes notification information related to the task into the interrupt register, to notify the management module 120 to execute the task in an interrupt mode. For example, a process of a memory manager (runtime) in the host 200 communicates with the simulation apparatus 100 by means of a socket by: the memory manager performing a write operation on the interrupt register of the proxy module 110 in the simulation apparatus 100, to write the notification information related to the task. After the notification information related to the task is written into the interrupt register of the proxy module 110, an interrupt is pulled to the management module 120. After the interrupt of the proxy module 110 is pulled to the management module 120, an interrupt handler (which is a part of a driver for the proxy module 110) of the proxy module 110 is executed, and the interrupt handler is in a kernel mode (when a process is caught in kernel code for execution due to a system call, it is in a kernel running mode (kernel mode), in which case the process has the highest privilege). Therefore, it is necessary to notify a scheduler in a user mode (when a process is executing a user's own code, it is in a user running mode (i.e., user mode), in which case the process has the lowest privilege). For example, the scheduler in the user mode may be signaled to receive a new task (i.e., the task sent by the host 200).

For example, as shown in FIG. 1A and FIG. 1B, the simulation apparatus 100 may further include a software module 150. The software module 150 includes an application (App) and a virtual machine system (guest OS). The application (App) includes various tools, a library, a scheduler, etc., and the virtual machine system (guest OS) may include an operating system kernel and a driver.

For example, the management module 120 has an operating system kernel running therein, for example, the operating system kernel may be a Linux 5.2 kernel, etc.

For example, the driver for the proxy module 110 is loaded into the operating system kernel to be executed. For example, the driver for the proxy module 110 may be loaded into the kernel by means of a kernel module. Kernel module is a concept of the operating system. The driver is typically loaded by the operating system as the kernel module.

At least one embodiment of the present disclosure further provides a simulation system.

For example, as shown in FIG. 2, the simulation system 1000 may include the simulation apparatus 100, the host 200, and the object model 300. It should be noted that for the mode of communication among the simulation apparatus 100, the host 200, and the object model 300, reference may be made to the above description of the embodiments of the simulation apparatus 100, and details of the same parts are not described herein.

For example, the host 200 is configured to obtain a task and send the task to the simulation apparatus 100. For example, the host 200 includes a memory manager, and the memory manager communicates with the simulation apparatus 100 to transmit the task to the simulation apparatus 100 and receive, from the simulation apparatus 100, feedback information returned by the object model 300 after processing work information related to the task.

For example, the object model 300 is configured to process the work information to obtain the feedback information.

For example, in some embodiments, the object model 300 is used for simulating functions of a hardware accelerator (e.g., the neural network processor), and may using a SystemC language for modeling. SystemC is a modeling platform composed of a set of C++ class libraries incorporating a simulation core, which can support hardware modeling at a system level, a behavioral description level, and a register transfer level.

For another example, the object model 300 may also use a Verlog language for modeling.

For example, the object model 300 is at an abstraction level of at least one of algorithm level modeling (ALM), system architecture modeling (SAM), transaction level modeling (TLM), and register transfer level (RTL).

For example, in some embodiments, the object model 300 may include an execution unit such as a matrix execution unit or a vector execution unit, a storage-related unit such as an on-chip static random-access memory (SRAM) or an SRAM controller, and a microcontroller unit (MCU), etc.

For example, in some embodiments, the object model 300 may model at least part of a read-store pipeline and a compute pipeline in the neural network processor, and collect statistics on an average execution time for each operation in the neural network processor. For example, with the CPU as an example, the compute pipeline represents an integer execution unit, a floating-point execution unit, etc. Accordingly, the read-store pipeline represents an IO operation, and the IO operation represents a load/save execution unit, also commonly referred to as LSU.

For example, the average execution time for each operation may represent a number of execution cycles at each stage (e.g., the stage represents a pipeline stage), i.e., a number of cycles for execution of each operation. For example, by collecting statistics on the average execution time for each operation, an approximate cycle-accurate model can be computed.

In order to improve the execution efficiency of the object model 300 as a cost-model, the object model 300 supports two modes: a functional mode/a performance mode. In the performance mode, only delays on the pipeline (e.g., the pipeline represents a linear communication model of pipeline segments exchanging data) are simulated, and actual operations corresponding to the read-store pipeline and the compute pipeline are not performed. Therefore, an accurately simulated cycle number can be obtained in the performance mode, which allows an execution speed to be increased by an order of magnitude as compared to in the functional mode.

In an embodiment of the present disclosure, the delays in the read-store pipeline and in the compute pipeline of the object model 300 are modeled by using SystemC. The object model 300 satisfies requirements of the AI compiler for a high-performance cost-model, and therefore, the object model 300 can serve as the cost-model for the AI compiler. The cost-model for the AI compiler can significantly improve inference time performance metrics of a resent50 network on a chip, for example, can reduce the inference time.

At least one embodiment of the present disclosure further provides a simulation method applied to a simulation system. The simulation system may be the simulation system provided in any one of the embodiments of the present disclosure, for example, the simulation system 1000 shown in FIG. 2.

FIG. 3 is a schematic flowchart of a simulation method according to at least one embodiment of the present disclosure.

As shown in FIG. 3, the simulation method may include the following steps S10 to S13.

Step S10: A host sends a task.

Step S11: A simulation apparatus receives and parses the task, to send work information related to the task to an object model.

Step S12: The object model processes the work information, to obtain feedback information.

Step S13: The simulation apparatus provides the feedback information to the host.

For example, with the simulation system 1000 shown in FIG. 2 as example, step S10 is implemented by the host 200. In step S10, the host 200 may receive the task from an external device, and send the task to the simulation apparatus 100. For example, in some embodiments, the task may be sent to the host 200 by a user through the external device.

For example, step S11 is implemented by the simulation apparatus 100. For example, the management module 120 in the simulation apparatus 100 may parse the task, and then the proxy module 110 in the simulation apparatus 100 sends the work information related to the task to the object model 300.

For example, step S12 is implemented by the object model 300. In step S12, the object model 300 may process the work information, to obtain the feedback information which may be sent to the simulation apparatus 100. For example, the feedback information may include a result of the processing of the work information by the object model 300. For example, when the task is to identify a target in an image, the feedback information may include a probability that the target is present in the image, etc.

For example, step S13 is implemented by the simulation apparatus 100. In step S13, the simulation apparatus 100 receives, via the proxy module 110, the feedback information returned by the object model 300 after processing the work information.

For the technical effects that can be achieved by the simulation method, reference may be made to the related description in the above embodiments of the simulation apparatus and the simulation system, and details of the same parts are not described herein.

At least one embodiment of the present disclosure further provides a simulation apparatus. The simulation apparatus may include one or more memories and one or more processors. It should be noted that the components of the above-mentioned simulation apparatus are merely exemplary and non-restrictive. Based on an actual application requirement, the simulation apparatus may further include other components. This is not specifically limited in the embodiments of the present disclosure.

For example, the one or more memories are configured to store computer-executable instructions in a non-transitory manner. The one or more processors are configured to run the computer-executable instructions. When the computer-executable instructions are run by the one or more processors, one or more steps of the simulation method according to any one of the embodiments of the present disclosure are implemented. For specific implementation of the steps of the simulation method and related explanations, reference may be made to the above embodiments of the simulation method, which will not be repeated herein.

For example, the processor and the memory may communicate with each other directly or indirectly.

For example, the processor and the memory may communicate with each other through a network. The network may include a wireless network, a wired network, and/or any combination of a wireless network and a wired network. The processor and the memory may also communicate with each other through a system bus, which is not limited in the present disclosure.

For example, the processor and the memory may be disposed at a server (or a cloud).

For example, the processor may control another component in the simulation apparatus to perform a desired function. The processor may be a central processing unit (CPU), a graphics processing unit (GPU), a network processor (NP), or the like. Alternatively, the processor may be another form of processing unit with a data processing capability and/or a program execution capability, for example, a digital signal processor (DSP), an application-specific integrated circuit (ASIC), a field programmable gate array (FPGA), a tensor processing unit (TPU) or other programmable logic devices, a discrete gate or transistor logic device, or a discrete hardware component. The central processing unit (CPU) may have an X86 or ARM architecture or the like.

For example, the memory may be a computer-readable medium and may include any combination of one or more computer program products, which may include various forms of computer-readable storage media, such as a volatile memory and/or a non-volatile memory. The volatile memory may include, for example, a random access memory (RAM) and/or a cache memory (cache). The non-volatile memory may include, for example, a read-only memory (ROM), a hard disk, an erasable programmable read-only memory (EPROM), a portable compact disk read-only memory (CD-ROM), a USB memory, and a flash memory. One or more computer-readable instructions may be stored on the computer-readable storage medium. The processor may execute the computer-readable instructions to implement various functions of the simulation apparatus. Various applications, various data, and the like may further be stored in the storage medium.

For the technical effects that can be achieved by the simulation apparatus, reference may be made to the related description in the above embodiments of the simulation method, and details of the same parts are not described herein.

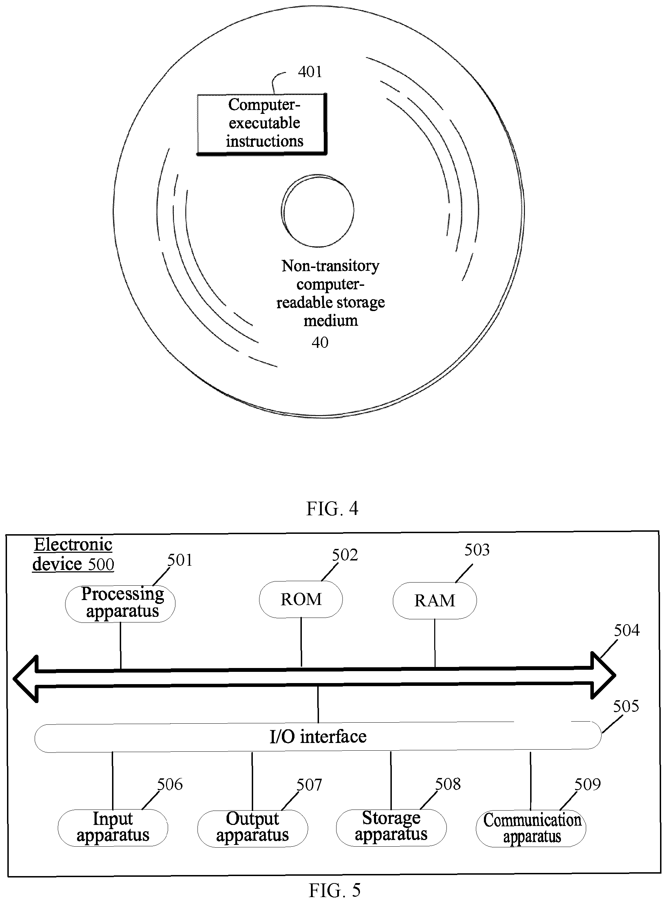

FIG. 4 is a schematic diagram of a non-transitory computer-readable storage medium according to at least one embodiment of the present disclosure. For example, as shown in FIG. 4, one or more computer-executable instructions 401 may be stored in a non-transitory computer-readable storage medium 40 in a non-transitory manner. For example, when the computer-executable instructions 401 are executed by a processor, one or more steps of the simulation method according to any one of the embodiments of the present disclosure can be performed.

For example, the non-transitory computer-readable storage medium 40 may be applied to the above-mentioned simulation apparatus. For example, the non-transitory computer-readable storage medium 40 may include the memory in the above-mentioned simulation apparatus.

For example, for the description of the non-transitory computer-readable storage medium 40, reference may be made to the description of the memory in the embodiments of the simulation apparatus, and details of the same parts are not described herein.

Referring now to FIG. 5, FIG. 5 shows a schematic diagram of a structure of an electronic device 500 suitable for implementing the embodiments of the present disclosure. The electronic device 500 may be a terminal device (e.g., a computer), a processor, etc., and may be configured to perform the simulation method in the above embodiments. The electronic device in this embodiment of the present disclosure may include, but is not limited to, a mobile terminal such as a mobile phone, a notebook computer, a digital broadcast receiver, a personal digital assistant (PDA for short), a tablet computer (portable android device, PAD for short), a portable media player (PMP for short), a vehicle-mounted terminal (such as a vehicle navigation terminal), and a wearable electronic device, and a fixed terminal such as a digital TV, a desktop computer, and a smart home device. The electronic device shown in FIG. 5 is merely an example, and shall not impose any limitation on the function and scope of use of the embodiments of the present disclosure.

As shown in FIG. 5, the electronic device 500 may include a processing apparatus (e.g., a central processing unit, a graphics processing unit) 501 that may perform a variety of appropriate actions and processing in accordance with a program stored in a read-only memory (ROM) 502 or a program loaded from a storage apparatus 508 into a random access memory (RAM) 503. The RAM 503 further stores various programs and data required for the operation of the electronic device 500. The processing apparatus 501, the ROM 502, and the RAM 503 are connected to each other through a bus 504. An input/output (I/O) interface 505 is also connected to the bus 504.

Generally, the following apparatuses may be connected to the I/O interface 505: an input apparatus 506 including, for example, a touch screen, a touchpad, a keyboard, a mouse, a camera, a microphone, an accelerometer, a gyroscope, etc.; an output apparatus 507 including, for example, a liquid crystal display (LCD), a speaker, a vibrator, etc.; the storage apparatus 508 including, for example, a tape, a hard disk, etc.; and a communication apparatus 509. The communication apparatus 509 may allow the electronic device 500 to perform wireless or wired communication with other devices to exchange data. Although FIG. 5 shows the electronic device 500 having various apparatuses, it should be understood that it is not required to implement or have all of the shown apparatuses. It may be an alternative to implement or have more or fewer apparatuses.

In particular, according to an embodiment of the present disclosure, the process described above with reference to the flowchart may be implemented as a computer software program. For example, an embodiment of the present disclosure includes a computer program product, which includes a computer program carried on a non-transitory computer-readable medium, where the computer program includes program code for performing the method shown in the flowchart, to perform one or more steps of the simulation method described above. In such an embodiment, the computer program may be downloaded and installed from a network through the communication apparatus 509, or installed from the storage apparatus 508, or installed from the ROM 502. The computer program, when executed by the processing apparatus 501, causes the processing apparatus 501 to perform the above-mentioned functions defined in the simulation method according to the embodiments of the present disclosure.

It should be noted that in the context of the present disclosure, a computer-readable medium may be a tangible medium that may contain or store a program used by or in combination with an instruction execution system, apparatus, or device. The computer-readable medium may be a computer-readable signal medium, a computer-readable storage medium, or any combination thereof. Examples of the computer-readable storage medium may include, but are not limited to: electric, magnetic, optical, electromagnetic, infrared, or semiconductor systems, apparatuses, or devices, or any combination thereof. A more specific example of the computer-readable storage medium may include, but is not limited to: an electrical connection having one or more wires, a portable computer magnetic disk, a hard disk, a random access memory (RAM), a read-only memory (ROM), an erasable programmable read-only memory (EPROM or flash memory), an optical fiber, a portable compact disk read-only memory (CD-ROM), an optical storage device, a magnetic storage device, or any suitable combination thereof. In the present disclosure, the computer-readable storage medium may be any tangible medium containing or storing a program which may be used by or in combination with an instruction execution system, apparatus, or device. In the present disclosure, the computer-readable signal medium may include a data signal propagated in a baseband or as a part of a carrier, the data signal carrying computer-readable program code. The propagated data signal may be in various forms, including but not limited to an electromagnetic signal, an optical signal, or any suitable combination thereof. The computer-readable signal medium may also be any computer-readable medium other than the computer-readable storage medium. The computer-readable signal medium can send, propagate, or transmit a program used by or in combination with an instruction execution system, apparatus, or device. The program code contained in the computer-readable medium may be transmitted by any suitable medium, including but not limited to: electric wires, optical cables, radio frequency (RF), etc., or any suitable combination of the above media.

The above computer-readable medium may be contained in the above electronic device. Alternatively, the computer-readable medium may exist independently, without being assembled into the electronic device.

The computer program code for performing the operations in the present disclosure may be written in one or more programming languages or a combination thereof, where the programming languages include, but are not limited to, an object-oriented programming language, such as Java, Smalltalk, and C++, and further include conventional procedural programming languages, such as "C" language or similar programming languages. The program code may be completely executed on a computer of a user, partially executed on a computer of a user, executed as an independent software package, partially executed on a computer of a user and partially executed on a remote computer, or completely executed on a remote computer or server. In the circumstance involving a remote computer, the remote computer may be connected to a computer of a user over any type of network, including a local area network (LAN) or a wide area network (WAN), or may be connected to an external computer (for example, connected over the Internet using an Internet service provider).

The flowcharts and block diagrams in the accompanying drawings illustrate the possibly implemented architecture, functions, and operations of the system, method, and computer program product according to various embodiments of the present disclosure. In this regard, each block in the flowchart or block diagram may represent a module, program segment, or part of code, and the module, program segment, or part of code contains one or more executable instructions for implementing the specified logical functions. It should also be noted that, in some alternative implementations, the functions marked in the blocks may also occur in an order different from that marked in the accompanying drawings. For example, two blocks shown in succession can actually be performed substantially in parallel, or they can sometimes be performed in the reverse order, depending on the functions involved. It should also be noted that each block in the block diagram and/or the flowchart, and a combination of the blocks in the block diagram and/or the flowchart may be implemented by a dedicated hardware-based system that executes specified functions or operations, or may be implemented by a combination of dedicated hardware and computer instructions.

The related units described in the embodiments of the present disclosure may be implemented by software, or may be implemented by hardware. For example, the name of a unit does not constitute a limitation on the unit itself under certain circumstances.

The functions described herein above may be performed at least partially by one or more hardware logic components. For example, without limitation, exemplary types of hardware logic components that may be used include: a field programmable gate array (FPGA), an application-specific integrated circuit (ASIC), an application-specific standard product (ASSP), a system-on-chip (SOC), a complex programmable logic device (CPLD), and the like.

In a first aspect, according to one or more embodiments of the present disclosure, there is provided a simulation apparatus. The simulation apparatus is used for simulating a neural network processor, and includes: a proxy module configured to communicate with an object model which simulates the neural network processor, and to serve as a proxy for the object model in the simulation apparatus; a management module configured to manage the simulation apparatus; and an interconnection module configured to communicatively connect the proxy module and the management module, where the simulation apparatus receives a task sent by a host, sends, via the proxy module, work information related to the task to the object model, receives, via the proxy module, feedback information returned by the object model after processing the work information, and provides the feedback information to the host.

According to one or more embodiments of the present disclosure, the proxy module communicates with the host by means of a socket, shared storage, and/or a message queue.

According to one or more embodiments of the present disclosure, an address space of the proxy module includes a proxy register space and a model space, where the proxy register space is used for defining registers of the neural network processor, and the registers of the neural network processor are located by means of memory addresses; and the model space is used for storing parameters of the neural network processor and inputs and/or outputs related to the task.

According to one or more embodiments of the present disclosure, the model space is mapped to a storage space in the object model.

According to one or more embodiments of the present disclosure, the model space is shared by the host and the proxy module.

According to one or more embodiments of the present disclosure, the address space of the proxy module further includes a configuration instruction space, where the configuration instruction space is used for storing configuration instructions of the registers of the neural network processor and control instructions related to the task.

According to one or more embodiments of the present disclosure, the proxy module includes a plurality of base address register spaces, and the plurality of base address register spaces include a first base address register space and a second base address register space; and the proxy register space corresponds to the first base address register space, and the configuration instruction space corresponds to the second base address register space.

According to one or more embodiments of the present disclosure, the configuration instruction space is mapped to a shared storage file shared by the proxy module and the host, and the shared storage file is located at the host.

According to one or more embodiments of the present disclosure, the proxy module is configured to provide content in the proxy register space and content in the model space to the object model based on content in the configuration instruction space, to configure and schedule the object model and perform work simulation.

According to one or more embodiments of the present disclosure, the proxy module communicates with the object model by means of a message queue.

According to one or more embodiments of the present disclosure, the management module has an operating system kernel running therein, and a driver for the proxy module is loaded into the operating system kernel.

According to one or more embodiments of the present disclosure, the proxy module includes an interrupt register, and the host writes notification information related to the task into the interrupt register, to notify the management module to execute the task in an interrupt mode.

According to one or more embodiments of the present disclosure, the simulation apparatus further includes an input-output module, where the input-output module communicates with the host by means of a socket, to receive the task, and the input-output module is configured to send the task to the proxy module or the management module.

According to one or more embodiments of the present disclosure, the simulation apparatus is implemented through a virtual simulation platform, and the management module is implemented through a virtual central processing unit.

In a second aspect, according to one or more embodiments of the present disclosure, there is provided a simulation system. The simulation system includes: the simulation apparatus according to any one of the embodiments of the present disclosure, the object model, and the host, where the host is configured to obtain a task and send the task to the simulation apparatus; and the object model is configured to process work information to obtain feedback information.

According to one or more embodiments of the present disclosure, the object model is at an abstraction level of algorithm level modeling, system architecture modeling, transaction level modeling, or register transfer level.

According to one or more embodiments of the present disclosure, the object model models at least part of a read-store pipeline and a compute pipeline in the neural network processor, and collects statistics on an average execution time for each operation in the neural network processor.

In a third aspect, according to one or more embodiments of the present disclosure, there is provided a simulation method applied to the simulation system according to any one of the embodiments of the present disclosure. The simulation method includes: sending a task by a host; receiving and parsing the task by the simulation apparatus, to send work information related to the task to an object model; processing the work information by the object model, to obtain feedback information; and providing the feedback information to the host by the simulation apparatus.

In a fourth aspect, according to one or more embodiments of the present disclosure, there is provided a non-transitory computer-readable storage medium storing computer-executable instructions, where when the computer-executable instructions are executed by a processor, the simulation method according to any one of the embodiments of the present disclosure is implemented.

The foregoing descriptions are merely preferred embodiments of the present disclosure and explanations of the applied technical principles. Those skilled in the art should understand that the scope of disclosure involved in the present disclosure is not limited to the technical solutions formed by specific combinations of the foregoing technical features, and shall also cover other technical solutions formed by any combination of the foregoing technical features or equivalent features thereof without departing from the foregoing concept of disclosure. For example, a technical solution formed by a replacement of the foregoing features with technical features with similar functions disclosed in the present disclosure (but not limited thereto) also falls within the scope of the present disclosure.

In addition, although the various operations are depicted in a specific order, it should not be construed as requiring these operations to be performed in the specific order shown or in a sequential order. Under certain circumstances, multitasking and parallel processing may be advantageous. Similarly, although several specific implementation details are included in the foregoing discussions, these details should not be construed as limiting the scope of the present disclosure. Some features that are described in the context of separate embodiments can also be implemented in combination in a single embodiment. In contrast, various features described in the context of a single embodiment may alternatively be implemented in a plurality of embodiments individually or in any suitable subcombination.

Although the subject matter has been described in a language specific to structural features and/or logical actions of the method, it should be understood that the subject matter defined in the appended claims is not necessarily limited to the specific features or actions described above. In contrast, the specific features and actions described above are merely exemplary forms of implementing the claims.

For the present disclosure, the following several points further need to be noted.
(1) The accompanying drawings of the embodiments of the present disclosure relate only to structures involved in the embodiments of the present disclosure, and for other structures, reference may be made to general designs.
(2) The embodiments of the present disclosure and features in the embodiments may be combined with each other without conflict, to obtain new embodiments.

The above description illustrates merely specific implementations of the present disclosure, but is not intended to limit the scope of protection of the present disclosure. The scope of protection of the present disclosure shall be subject to the scope of protection of the claims.

## Claims

1. A simulation apparatus for simulating a neural network processor, **characterized in that** the apparatus comprises:
a proxy module configured to communicate with an object model which simulates the neural network processor, and to serve as a proxy for the object model in the simulation apparatus;
a management module configured to manage the simulation apparatus; and
an interconnection module configured to communicatively connect the proxy module and the management module,
wherein the simulation apparatus receives a task sent by a host, sends, via the proxy module, work information related to the task to the object model, receives, via the proxy module, feedback information returned by the object model after processing the work information, and provides the feedback information to the host.

2. The simulation apparatus according to claim 1, **characterized in that** the proxy module communicates with the host by means of a socket, shared storage, and/or a message queue.

3. The simulation apparatus according to claim 1 or 2, **characterized in that** an address space of the proxy module comprises a proxy register space and a model space, wherein
the proxy register space is used for defining registers of the neural network processor, and the registers of the neural network processor are located by means of memory addresses; and
the model space is used for storing parameters of the neural network processor and inputs and/or outputs related to the task.

4. The simulation apparatus according to claim 3, **characterized in that** the model space is mapped to a storage space in the object model.

5. The simulation apparatus according to claim 3 or 4, **characterized in that** the model space is shared by the host and the proxy module.

6. The simulation apparatus according to any one of claims 3 to 5, **characterized in that** the address space of the proxy module further comprises a configuration instruction space, wherein
the configuration instruction space is used for storing configuration instructions of the registers of the neural network processor and control instructions related to the task.

7. The simulation apparatus according to claim 6, **characterized in that**
the proxy module comprises a plurality of base address register spaces, and the plurality of base address register spaces comprise a first base address register space and a second base address register space; and
the proxy register space corresponds to the first base address register space, and the configuration instruction space corresponds to the second base address register space.

8. The simulation apparatus according to claim 6, **characterized in that** the configuration instruction space is mapped to a shared storage file shared by the proxy module and the host, and the shared storage file is located at the host.

9. The simulation apparatus according to claim 6, **characterized in that** the proxy module is configured to provide content in the proxy register space and content in the model space to the object model based on content in the configuration instruction space, to configure and schedule the object model and perform work simulation.

10. The simulation apparatus according to any one of claims 1 to 9, **characterized in that** the proxy module communicates with the object model by means of a message queue.

11. The simulation apparatus according to any one of claims 1 to 10, **characterized in that** the management module has an operating system kernel running therein, and a driver for the proxy module is loaded into the operating system kernel.

12. The simulation apparatus according to any one of claims 1 to 11, **characterized in that** the proxy module comprises an interrupt register, and the host writes notification information related to the task into the interrupt register, to notify the management module to execute the task in an interrupt mode.

13. The simulation apparatus according to any one of claims 1 to 12, **characterized by** further comprising an input-output module,
wherein the input-output module communicates with the host by means of a socket, to receive the task, and
the input-output module is configured to send the task to the proxy module or the management module.

14. The simulation apparatus according to any one of claims 1 to 13, **characterized in that** the simulation apparatus is implemented through a virtual simulation platform, and the management module is implemented through a virtual central processing unit.

15. A simulation system, **characterized by** comprising:
the simulation apparatus according to any one of claims 1 to 14, the object model, and the host,
wherein the host is configured to obtain a task and send the task to the simulation apparatus; and
the object model is configured to process work information to obtain feedback information.

16. The simulation system according to claim 15, **characterized in that** the object model is at an abstraction level of algorithm level modeling, system architecture modeling, transaction level modeling, or register transfer level.

17. The simulation system according to claim 15 or 16, **characterized in that** the object model models at least part of a read-store pipeline and a compute pipeline in the neural network processor, and collects statistics on an average execution time for each operation in the neural network processor.

18. A simulation method applied to the simulation system according to any one of claims 15 to 17, **characterized in that** the method comprises:
sending the task by the host;
receiving and parsing the task by the simulation apparatus, to send the work information related to the task to the object model;
processing the work information by the object model, to obtain the feedback information; and
providing the feedback information to the host by the simulation apparatus.

19. A non-transitory computer-readable storage medium storing computer-executable instructions, **characterized in that** the computer-executable instructions, when executed by a processor, are configured to implement the simulation method according to claim 18.
